# EUROPÄISCHE PATENTSCHRIFT

(11) **EP 3 206 040 B1**
(45) Veröffentlichungstag und Bekanntmachung des Hinweises auf die Patenterteilung: **03.07.2019**
(21) Anmeldenummer: 17153856.4
(22) Anmeldetag: 31.01.2017
(51) Int. Cl.: G01R 31/02, H02H 3/16, H02H 3/33, H02H 5/10

(54) **VERFAHREN UND VORRICHTUNGEN ZUR ERKENNUNG EINER UNTERBRECHUNG EINER SCHUTZLEITERVERBINDUNG**
METHOD AND DEVICE FOR DETECTING AN INTERRUPTION OF A PROTECTIVE EARTH CONNECTION
MÉTHODE ET APPAREIL POUR LA DÉTECTION D'UNE INTERRUPTION D'UNE CONNECTION À LA TERRE

(30) Priorität: 10.02.2016 DE 102016202021
(43) Veröffentlichungstag der Anmeldung: 16.08.2017
(60) Teilanmeldung: 18158533.2
(73) Patentinhaber: Bender GmbH & Co. KG, 35305 Grünberg (DE)
(72) Erfinder: HACKL, Dieter, 35463 Fernwald (DE); SELLNER, Harald, 35305 Grünberg (DE)
(74) Vertreter: advotec.

(56) Entgegenhaltungen:
- EP-A1- 2 006 694
- EP-A1- 2 568 557
- EP-A1- 2 568 560
- EP-A2- 2 574 939
- WO-A1-03/100938
- DE-A1- 19 826 410
- DE-U1- 20 220 276

## Beschreibung

Die Erfindung betrifft ein Verfahren und eine elektrische Schutzvorrichtung zur Erkennung einer Unterbrechung einer Schutzleiterverbindung zu einem Subsystem eines ungeerdeten Stromversorgungssystems.

Weiterhin betrifft die Erfindung ein Verfahren und eine elektrische Schutzvorrichtung zur Erkennung einer Unterbrechung einer Schutzleiterverbindung zu einem Subsystem eines geerdeten Wechselstromversorgungssystems.

In einem Stromversorgungssystem ist eine Schutzerdung von leitfähigen berührbaren Teilen eines elektrischen Betriebsmittels als Schutzvorkehrung ein wichtiger Bestandteil der normativ geforderten Schutzmaßnahme "Schutz durch automatische Abschaltung der Stromversorgung". Dies gilt unabhängig davon, ob es sich um die Netzform eines ungeerdeten Stromversorgungsystems (frz. Isolé Terre - IT-Netz) oder eines geerdeten Stromversorgungssystems (frz. Terre Neutre - TN-Netz oder frz. Terre Terre - TT-Netz) handelt.

Die Schutzerdung eines Subsystems eines verzweigten Stromversorgungssystems durch eine Schutzleiterverbindung zu dem Subsystem verdient daher besondere Beachtung, da dieser Schutz in den meisten Fällen durch eine Unterbrechung des Schutzleiters unwirksam wird. Unter Subsystem sei hier eine abschaltbare Einheit eines Gesamt-Stromversorgungssystems verstanden. Dieses Subsystem umfasst in der Regel ein oder mehrere elektrische Betriebsmittel.

Kommt zu der Unterbrechung einer Schutzleiterverbindung (erster Fehler) ein weiterer (zweiter) Fehler hinzu, wie beispielsweise das Versagen der Basisisolierung durch Überbrücken von Luft- und Kriechstrecken oder aufgrund einer schadhaften Isolierung, besteht ein erhöhtes Risiko für einen elektrischen Schlag.

Da das Auftreten dieser Zweifehlersituation in Stromversorgungsystemen nicht vernachlässigbar gering ist, hat sich in geerdeten Stromversorgungssystemen als zusätzlicher Schutz der Einsatz von Fehlerstrom-Schutzeinrichtungen (RCDs) durchgesetzt.

In vielen industriellen Stromversorgungsystemen ist der Einsatz von RCDs als zusätzlicher Schutz gegen elektrischen Schlag jedoch nicht möglich, da beispielsweise durch in dem Stromversorgungssystem vorhandene sehr große Netzableitkapazitäten auch ohne einen zusätzlichen Fehlerstrom bereits ein Ableitstrom fließt, der deutlich über 30 mA liegen kann und somit in dem Stromversorgungssystem vorhandene RCDs sofort zum Auslösen bringen würde.

Kann in einem geerdeten Stromversorgungssystem das RCD aufgrund zu hoher Ableitströme nicht eingesetzt werden oder ist das eingesetzte RCD nicht für den Schutz gegen elektrischen Schlag geeignet (nur für den Brand- und Anlagenschutz ausgelegt), so besteht bei einer unterbrochenen Schutzleiterverbindung und einem zweiten Fehler die Gefahr, dass eine Person bei bestimmungsgemäßer Bedienung des Betriebsmittels einen gefährlichen Elektrounfall erleidet, da sich der Fehlerstromkreis über den Körper der Person schließt.

Bei intakter Schutzleiterverbindung hingegen fließt der Fehlerstrom bei Versagen der Basisisolierung fast ausschließlich über den Schutzleiter zurück zum Einspeisepunkt des geerdeten Stromversorgungssystems. Allerdings führt dies - bei richtiger Auslegung des geerdeten Stromversorgungssystems - zu sehr hohen Erdschlussströmen und meistens auch zu Berührungsspannungen mit gefährlich hoher Amplitude. Aus diesem Grund muss ein geerdetes Stromversorgungssystem bei einem ersten Fehler schnell genug abgeschaltet werden.

Besonderes Augenmerk im Hinblick auf Schutzvorkehrungen verdient die Installation von Umrichtersystemen in geerdeten Stromversorgungssystemen. Die Schutzleiterverbindung zu einem Umrichtersystem ist besonders kritisch, da Isolationsfehler am Ausgang des Umrichtersystems gegen berührbare und leitfähige Teile eines umrichtergesteuerten Antriebs zu Fehlerströmen führen können, die neben netzfrequenten Anteilen auch ein recht breitbandiges Spektrum an umrichterspezifischen Spektralanteilen von Gleichstrom-Komponenten bis hin zu Anteilen im MHz-Bereich aufweisen können.

Auch ist zu beachten, dass große Ableitkapazitäten zwischen den Ausgangsphasen des Umrichters und dem Antriebsgehäuse (Ausgangsfilter) für die höherfrequenten Anteile eine niederimpedante Verbindung darstellen können.

Herkömmliche RCDs vom Typ A liefern hier keinen zuverlässigen zusätzlichen Schutz. Eine Berührung des umrichtergesteuerten Antriebs kann bei einer fehlerhaften Schutzleiterverbindung zu einem elektrischen Schlag führen, ohne dass ein RCD Typ A dies erkennt. Selbst der Einsatz mischfrequenzsensitiver RCDs vom Typ F hilft meist nicht zuverlässig gegen die Gefährdung durch elektrischen Schlag.

Betriebsmäßig liegen die Ableitströme im Schaltfrequenzbereich des Umrichters (kHz-Bereich) meistens schon deutlich über 30 mA, häufig wird in leistungsstarken Umrichterantrieben sogar betriebsmäßig die Ableitstromgrenze von 300 mA überschritten. Der Einsatz eines RCDs ist in solchen Systemen selbst aus Brandschutzgründen nicht möglich.

Eine der wichtigsten Schutzvorkehrungen ist vor allem in leistungsstarken Umrichterantrieben somit eine zuverlässige Schutzerdung der berührbaren leitfähigen Antriebsteile.

Auch in einem ungeerdeten Stromversorgungssystem, bei dem definitionsgemäß alle aktiven Teile des Stromversorgungssystems von dem Erdpotenzial - gegenüber Erde - getrennt und die angeschlossenen Betriebsmittel durch einen Schutzleiter mit einer Erdungsanlage verbunden sind, kann eine Zweifehlersituation bei Berührung eines Betriebsmittels gefährlich werden, wenn es sich um ein weit ausgedehntes ungeerdetes Stromversorgungssystem mit einer demzufolge großen Gesamtnetzableitkapazität handelt. Der Fehlerstromkreis wird in dieser Zweifehlersituation über die berührende Person und die Netzableitkapazitäten geschlossen.

Bei intakter Schutzleiterverbindung fließt der Fehlerstrom bei fehlerhafter Basisisolierung nahezu vollständig über den Schutzleiter und die Netzableitkapazitäten. Dies führt auch im einfachen Fehlerfall in einem ungeerdeten Stromversorgungssystem nur zu ungefährlichen Berührungsspannungen an dem Betriebsmittel. Aus diesem Grund kann ein ungeerdetes Stromversorgungssystem bei einem ersten Fehler weiterbetrieben werden.

Um der durch einen unterbrochenen Schutzleiter entstehenden Gefährdung zu begegnen, sind aus dem Stand der Technik Lösungen bekannt, die jedoch teils erhebliche Nachteile aufweisen.

Die Gebrauchsmusterschrift DE 202 20 276 U1 beschreibt eine Vorrichtung zur Überwachung eines elektrischen Stromnetzes, die eine Messeinheit zur Messung von elektrischen Einzelgrößen (Strom, Spannung, Leistung) und Sicherheitsgrößen (Schutzleiterwiderstand, Isolationswiderstand, Geräteableitstrom) sowie eine Auswerte- und eine Schalteinheit aufweist.

In der Offenlegungsschrift DE 198 26 410 A1 sind ein Verfahren und eine Einrichtung zur Isolations- und Fehlerstromüberwachung offenbart. Als Maß für den resistiven Fehlerstrom wird das Produkt zwischen der Amplitude des erfassten Wechselstromanteils des Differenzstroms und dem Kosinus des Phasenwinkels zwischen Wechselstromanteil und Netzwechselspannung gebildet. Durch die Unterscheidung von resistiven Fehlerströmen und kapazitiven Ableitströmen ist das Verfahren auch in ausgedehnten Wechselstromnetzen einsetzbar. Es existieren weitere Vorschläge für eine selektive Fehlerstromerfassung, welche zwischen Ableitströmen und Fehlerströmen unterscheiden kann. RCDs auf Basis dieser Ideen sind jedoch nicht verfügbar, da die zuverlässige Funktion im 3-Phasen-Wechselstrom-System bislang nicht nachgewiesen werden konnte.

Weiterhin sind Geräte auf dem Markt verfügbar, die den Einsatz von Fehlerstrom-Schutzeinrichtungen zum Schutz gegen elektrischen Schlag auch in industriellen Systemen ermöglichen sollen, indem kapazitive Ableitströme kompensiert werden. Allerdings ist nicht bekannt, wie zuverlässig derartige Schutzeinrichtungen in weitverzweigten Industrienetzen mit wechselnden, komplexen Betriebszuständen arbeiten.

Schließlich existieren Schleifenüberwachungsgeräte auf dem Markt, die eine Schutzleiteranschlussüberwachung direkt an den Betriebsmitteln vornehmen. Bei einer Vielzahl von Betriebsmitteln an verschiedenen Netzzweigen werden entsprechend viele Schleifenüberwachungsgeräte benötigt.

Der vorliegenden Erfindung liegt somit die Aufgabe zu Grunde, ein Verfahren und eine elektrische Schutzeinrichtung anzugeben, die sowohl in geerdeten als auch in ungeerdeten, verzweigten, d.h. mit abschaltbaren Einheiten (Subsystemen) versehenen, Stromversorgungssystemen eine Unterbrechung einer Schutzleiterverbindung zu einem Subsystem im Vorfeld erkennen, ohne dass es zu einer Betriebsunterbrechung kommt.

Diese Aufgabe wird für ein ungeerdetes Stromversorgungssystem gelöst durch ein erfindungsgemäßes Verfahren nach Anspruch 1.

Der dem Verfahren zugrunde liegende Gedanke beruht darauf, dass durch die Unterbrechung der Schutzleiterverbindung zu einem Subsystem die Summe der Netzableitkapazitäten des ungeerdeten Stromversorgungssystems - die Gesamtnetzableitkapazität - um den Betrag der Netzableitkapazität des Subsystems - die Teilnetzableitkapazität - reduziert wird. Die notwendige Unterscheidung zwischen einem im Betrieb befindlichen Subsystem mit unterbrochener Schutzleiterverbindung und einem abgeschalteten Subsystem erfolgt durch eine Auswertung der über das Stromversorgungssystem aufgenommenen aktuellen Gesamtleistung.

Das Abschalten eines Subsystems bedeutet in der Praxis eine Auftrennung der aktiven Leiter, nicht auch ein Auftrennen der zu dem Subsystem führenden Schutzleiterverbindung. Bei einer Abschaltung des Subsystems wird also sowohl die Gesamtleistung des Stromversorgungssystems um den Betrag der von dem Subsystems im eingeschalteten Zustand aufgenommenen Teilleistung als auch die Gesamtnetzableitkapazität des Stromversorgungssystems um die Teilnetzableitkapazität des Subsystems reduziert.

Bei Unterbrechung des Schutzleiters hingegen wird nur die Gesamtnetzableitkapazität des Stromversorgungssystems um die Teilnetzableitkapazität des Subsystems reduziert ohne zeitlich korrelierten Einfluss auf die Gesamtlaststromaufnahme bzw. die Gesamtleistungsaufnahme des Stromversorgungssystems.

Somit kann ausgehend von einer bekannten, für das fehlerfreie Stromversorgungssystem gültigen Referenz-Gesamtnetzableitkapazität durch Vergleich mit einem gemessenen aktuellen Wert der Gesamtnetzableitkapazität eine für ein abgeschaltetes Subsystem oder für ein Subsystem mit unterbrochenem Schutzleiter charakteristische Verringerung der Gesamtnetzableitkapazität festgestellt werden. Die Unterscheidung, ob es sich dabei um eine Schutzleiterunterbrechung oder eine betriebsgemäße Abschaltung des Subsystems handelt, wird aufgrund eines Vergleichs zwischen der bekannten aufgenommenen Referenz-Gesamtleistung des Stromversorgungssystems bei im Betrieb befindlichen Subsystem und der aktuell aufgenommenen Gesamtleistung getroffen.

Das Messen und Prüfen der aktuellen Gesamtnetzableitkapazität und der aktuellen Gesamtleistung sowie gegebenenfalls die Signalisierung der Schutzleiterunterbrechung erfolgen dabei während des Betriebs des Stromversorgungssystems kontinuierlich in voreinstellbaren Zeitabständen.

Für ein geerdetes Stromversorgungssystem wird die Aufgabe gelöst durch ein erfindungsgemäßes Verfahren nach Anspruch 2.

In diesem Fall beruht der dem Verfahren zugrunde liegende Gedanke zunächst darauf, dass wie bei dem ungeerdeten Stromversorgungssystem durch die Unterbrechung der Schutzleiterverbindung zu einem Subsystem die Summe der Netzableitkapazitäten des geerdeten Stromversorgungssystems um den Betrag der Netzableitkapazität des Subsystems reduziert wird. Damit verbunden ist in dem geerdeten Stromversorgungssystem eine messbare Verringerung des Differenzstroms des gesamten geerdeten Stromversorgungssystems - des Gesamtdifferenzstroms - um die kapazitiven Ableitstromanteile des Subsystems, d.h. um den Teildifferenzstrom des Subsystems.

Die notwendige Unterscheidung zwischen einem im Betrieb befindlichen Subsystem mit unterbrochener Schutzleiterverbindung und einem abgeschalteten Subsystem erfolgt wie bei dem ungeerdeten Stromversorgungssystem durch eine Auswertung der über das geerdete Stromversorgungssystem aufgenommenen aktuellen Gesamtleistung.

Mit Vorteil erfolgt das Ermitteln der Referenzwerte Referenz-Gesamtnetzableitkapazität, Referenz-Gesamtdifferenzstrom, Referenz-Ableitstromspektrum bei einer Erstinbetriebnahme und unmittelbar nach einer Wiederholungsprüfung des Stromversorgungssystems.

Bei einer Erstinbetriebnahme und unmittelbar nach einer Wiederholungsprüfung kann davon ausgegangen werden, dass sich das Stromversorgungssystem, insbesondere die Schutzleiterverbindungen, in fehlerfreiem Zustand befindet/befinden, sodass in dieser Phase zuverlässige Referenzwerte ermittelt werden können.

Alternativ oder ergänzend zu der Ermittlung der Referenzwerte im Rahmen der Erstinbetriebnahme und der Wiederholungsprüfung erfolgt das Ermitteln der Referenzwerte Referenz-Gesamtnetzableitkapazität, Referenz-Gesamtdifferenzstrom, Referenz-Ableitstromspektrum durch eine Filterung der gemessenen Werte.

Mittels einer Filterung, beispielsweise durch eine gleitende Mittelwertbildung, wird eine kontinuierliche, träge Anpassung des Referenzwertes an sich ändernde Systembedingungen erreicht. Sprunghafte Änderungen des aktuellen Messwertes gegenüber dem so ermittelten trägen Referenzwert werden als fehlerhafte Ereignisse (Schutzleiter-Abriss) erkannt.

In Umsetzung des erfindungsgemäßen Verfahrens nach Anspruch 1 wird die Aufgabe für ein ungeerdetes Stromversorgungssystem gelöst durch eine erfindungsgemäße elektrische Schutzvorrichtung nach Anspruch 5.

Die elektrische Schutzvorrichtung weist eine Vorrichtung zur Messung der Gesamtnetzableitkapazität des ungeerdeten Stromversorgungssystems auf, mit der während des Betriebs des Stromversorgungssystems die aktuelle Gesamtnetzableitkapazität ermittelt wird. Darüber hinaus ist diese Vorrichtung zur Messung der Gesamtnetzableitkapazität auch geeignet, die Gesamtnetzableitkapazität des Stromversorgungssystems im Rahmen der Erstinbetriebnahme oder einer Wiederholungsprüfung zu messen.

Weiterhin umfasst die elektrische Schutzvorrichtung eine Vorrichtung zur Messung einer über das ungeerdete Stromversorgungssystem aufgenommenen Gesamtleistung sowie eine Auswertungs-Prozesseinheit zur Prüfung der gemessenen Gesamtnetzableitkapazität und der gemessenen aufgenommenen Gesamtleistung und zur Signalisierung der Unterbrechung der Schutzleiterverbindung.

Die Vorrichtung zur Messung einer über das ungeerdete Stromversorgungssystem aufgenommenen Gesamtleistung kann bevorzugt aus einem bereits vorhandenen System zur Bestimmung der Netzqualität bestehen (PQ (Performance Quality) - Gerät).

Die vorgenannten Vorrichtungen zur Messung der Gesamtnetzableitkapazität, zur Messung der Gesamtleistung sowie die Auswertungs-Prozesseinheit sind jeweils als funktionale Einheiten zu verstehen, die in getrennten, teilweise bereits vorhandenen Messeinrichtungen, beherbergt sein können oder aber, wie im Folgenden beschrieben, zu baulichen Einheiten zusammengefasst sind.

In weiterer Ausgestaltung bilden die Vorrichtung zur Messung der Gesamtnetzableitkapazität und ein Isolationsüberwachungsgerät ein erweitertes Isolationsüberwachungsgerät als bauliche Einheit aus.

Ein in dem ungeerdeten Stromversorgungssystem nach der Norm vorgeschriebenes Isolationsüberwachungsgerät kann vorteilhaft durch die Vorrichtung zur Messung der Gesamtnetzableitkapazität erweitert werden. Damit kann nicht nur die Gesamtnetzableitkapazität im Sinne der vorliegenden Aufgabenstellung ermittelt werden, sondern die Gesamtnetzableitkapazität kann auch zur optimierten Bestimmung des Isolationswiderstandswertes herangezogen werden.

Mit Vorteil bilden das erweiterte Isolationsüberwachungsgerät, die Vorrichtung zur Messung der über das ungeerdete Stromversorgungssystem aufgenommenen Gesamtleistung und die Auswertungs-Prozesseinheit ein integriertes Kombigerät zur Erkennung einer Schutzleiterunterbrechung als bauliche Einheit aus.

Die Verwendung eines integrierten Kombigerätes zur erfindungsgemäßen Erkennung einer Schutzleiterunterbrechung erleichtert die Inbetriebnahme der elektrischen Schutzvorrichtung und erhöht deren Zuverlässigkeit, da die Erfassung, Prüfung und Auswertung der Messwerte nicht in einem übergeordneten Leitsystem erfolgen muss, sondern durch eine für diese Aufgabe spezialisierte Auswertungs-Prozesseinheit des integrierten Kombigerätes erfolgt.

In Umsetzung des erfindungsgemäßen Verfahrens nach Anspruch 2 wird die Aufgabe für ein geerdetes Stromversorgungssystem gelöst durch eine erfindungsgemäße elektrische Schutzvorrichtung nach Anspruch 8.

Dazu umfasst die elektrische Schutzvorrichtung eine Vorrichtung zur Messung eines Gesamtdifferenzstroms des geerdeten Stromversorgungssystems, eine Vorrichtung zur Messung einer über das geerdete Stromversorgungssystem aufgenommenen Gesamtleistung sowie eine Auswertungs-Prozesseinheit zur Prüfung des gemessenen Gesamtdifferenzstroms und der gemessenen aufgenommenen Gesamtleistung und zur Signalisierung der Unterbrechung der Schutzleiterverbindung.

Auch für die in dem geerdeten Stromversorgungssystem vorgesehene elektrische Schutzvorrichtung zur Erkennung einer Unterbrechung einer Schutzleiterverbindung gilt, dass die vorgenannten Vorrichtungen sowie die Auswertungs-Prozesseinheit jeweils als funktionale Einheiten zu verstehen sind, die in getrennten, teilweise bereits vorhandenen Messeinrichtungen, beherbergt sein können oder, gegebenenfalls mit bereits vorhandenen Einrichtungen, zu baulichen Einheiten zusammengefasst werden können.

Bevorzugt bilden die Vorrichtung zur Messung des Gesamtdifferenzstroms, die Vorrichtung zur Messung der über das geerdete Stromversorgungssystem aufgenommenen Gesamtleistung und die Auswertungs-Prozesseinheit ein integriertes Kombigerät auf der Basis eines Gerätes zur Bestimmung der Netzqualität (PQ-Gerät) als bauliche Einheit aus.

Die Integration auf Basis eines - in den meisten Stromversorgungssystemen ohnehin vorhandenen - Gerätes zur Bestimmung der Netzqualität vereinfacht den schaltungstechnischen Aufbau der elektrischen Schutzvorrichtung, da von dem PQ-Gerät meist alle benötigten Messwerte (Laststrom bzw. Leistungsaufnahme und Gesamtdifferenzstrom) mit hinreichender Genauigkeit erfasst werden.

Mit den erfindungsgemäßen Verfahren und deren Umsetzung mittels der korrespondierenden elektrischen Schutzvorrichtungen wird eine wirksame Überwachung der Schutzleiterverbindung möglich. Insbesondere kann eine Unterbrechung einer Schutzleiterverbindung zu einem Subsystem im Vorfeld erkannt werden, sodass es zu keiner zeitaufwändigen und kostenverursachenden Betriebsunterbrechung kommt.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: eine Darstellung einer Schutzerdung in einem ungeerdeten Stromversorgungssystem mit einer erfindungsgemäßen elektrischen Schutzvorrichtung und
- **Fig. 2:**: eine Darstellung einer Schutzerdung in einem geerdeten Stromversorgungssystem mit einer erfindungsgemäßen elektrischen Schutzvorrichtung.

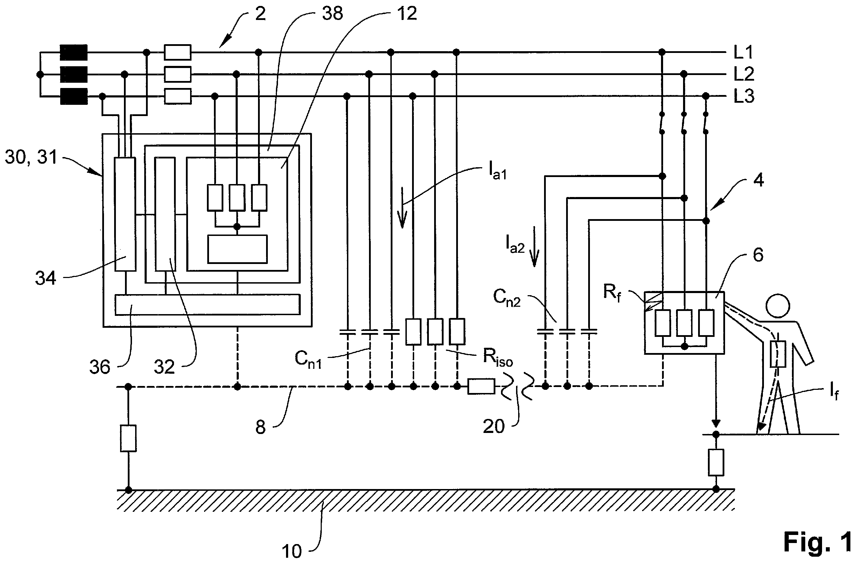

**Fig. 1** zeigt eine Schutzerdung in einem ungeerdeten (IT) Dreiphasen-(Wechsel-)Stromversorgungssystem 2 mit den aktiven Leitern L1, L2, L3. Das Stromversorgungsystem 2 umfasst ein abschaltbares Subsystem 4 mit einem Betriebsmittel 6, das über eine zu dem Subsystem 4 führende Schutzleiterverbindung 8 mit einer Erdungsanlage verbunden ist. Alle aktiven Teile des ungeerdeten Stromversorgungssystems 2 sind definitionsgemäß gegenüber Erde 10 getrennt. Das Stromversorgungssystem 2 ist weiterhin gekennzeichnet durch die Netzableitkapazitäten Cn1 eines Hauptsystems und die Netzableitkapazitäten Cn2 des Subsystems 4, wobei die Summe der Netzableitkapazitäten Cn1 und Cn2 aufgrund ihrer Parallelschaltung eine Gesamtnetzableitkapazität des ungeerdeten Stromversorgungssystems 2 ergibt. Über die Netzableitkapazitäten Cn1 und Cn2 fließen (in fehlerfreiem Zustand und bei eingeschaltetem Subsystem 4) jeweils die Ableitströme Ia1 und Ia2, die im vorliegenden Fall des Wechselstromsystems proportional zu den jeweiligen Netzableitkapazitäten Cn1 und Cn2 sind.

Ein zwischen den aktiven Leitern L1, L2, L3 und Erde 10 angeschlossenes Isolationsüberwachungsgerät 12 überwacht ein Isolationswiderstand Riso des Stromversorgungsystems 2 (in vereinfachter Darstellung ist vorliegend nur der Isolationswiderstand Riso des Hauptsystems eingezeichnet, erfasst werden aber auch parallel geschaltete, nicht dargestellte Isolationswiderstände vorhandener Subsysteme).

In dem dargestellten Betriebsfall ist eine Unterbrechung 20 (erster Fehler) der Schutzleiterverbindung 8 zu dem Subsystem 4 aufgetreten. Kommt nun ein zweiter Fehler Rf bei dem an das Subsystem 4 angeschlossenen Betriebsmittel 6 hinzu (Zweifehlersituation), beispielsweise aufgrund einer schadhaften Isolierung, so fließt ein Fehlerstrom If über die berührende Person und die Netzableitkapazitäten Cn1. Insbesondere in weitläufigen Stromversorgungssystemen 2 mit großen Netzableitkapazitäten Cn1 kann der Fehlerstrom If gefährlich hohe Werte annehmen.

In Umsetzung des erfindungsgemäßen Verfahrens weist die erfindungsgemäße elektrische Schutzvorrichtung 30 zur Erkennung der Unterbrechung 20 der Schutzleiterverbindung 8 Messvorrichtungen 32, 34 und eine Auswertungs-Prozesseinheit 36 auf. Im Einzelnen sind dies eine Vorrichtung 32 zur Messung der Gesamtnetzableitkapazität des ungeerdeten Stromversorgungssystems 2, eine Vorrichtung 34 zur Messung der über das ungeerdete Stromversorgungssystem 2 aufgenommenen Gesamtleistung sowie eine Auswertungs-Prozesseinheit 36 zur Prüfung der gemessenen Gesamtnetzableitkapazität und der gemessenen aufgenommenen Gesamtleistung und zur Signalisierung der Unterbrechung 20 der Schutzleiterverbindung 8.

In dem dargestellten Ausführungsbeispiel bildet die Vorrichtung 32 zur Messung der Gesamtnetzableitkapazität zusammen mit dem Isolationsüberwachungsgerät 12 ein erweitertes Isolationsüberwachungsgerät 38, welches wiederum zusammen mit der Vorrichtung 34 zur Messung der Gesamtleistung und der Auswertungs-Prozesseinheit 36 ein integriertes Kombigerät 31 als bauliche Einheit ausbildet.

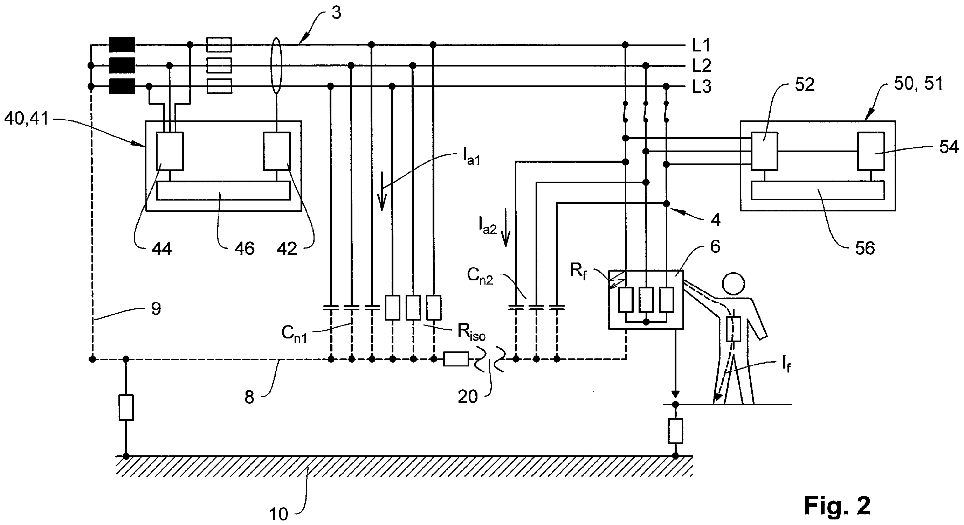

In Fig. 2 ist der gleiche Betriebsfall (Zweifehlersituation) wie für das ungeerdete Stromversorgungssystem 2 aus Fig. 1 für ein geerdetes (TN) Dreiphasen-(Wechsel-)Stromversorgungssystem 3 mit den aktiven Leitern L1, L2, L3 gezeigt. Im Gegensatz zu dem ungeerdeten Stromversorgungssystem 2 (Fig. 1) weist das geerdete Stromversorgungssystem 3 an seinem Einspeisepunkt eine direkte Erdverbindung 9 auf. Aufgrund der Unterbrechung 20 der Schutzleiterverbindung 8 fließt der Fehlerstrom If vollständig über die berührende Person.

Erfindungsgemäß wird durch eine Messung des Gesamtdifferenzstroms und der Gesamtleistung des geerdeten Stromversorgungssystems 3 in Verbindung mit einer Auswertung der Messergebnisse eine Unterbrechung 20 der Schutzleiterverbindung 8 erkannt.

Dazu weist die elektrische Schutzvorrichtung 40 in Umsetzung des erfindungsgemäßen Verfahrens eine Vorrichtung 42 zur Messung eines Gesamtdifferenzstroms des geerdeten Stromversorgungssystems 3, eine Vorrichtung 44 zur Messung einer über das geerdete Stromversorgungssystem aufgenommenen Gesamtleistung sowie eine Auswertungs-Prozesseinheit 46 zur Prüfung des gemessenen Gesamtdifferenzstroms und der gemessenen aufgenommenen Gesamtleistung und zur Signalisierung der Unterbrechung 20 der Schutzleiterverbindung 8 auf.

In dem dargestellten Ausführungsbeispiel bilden die Vorrichtung 42 zur Messung des Gesamtdifferenzstroms, die Vorrichtung 44 zur Messung der aufgenommenen Gesamtleistung und die Auswertungs-Prozesseinheit 46 ein integriertes Kombigerät 41 auf der Basis eines Gerätes zur Bestimmung der Netzqualität als bauliche Einheit aus.

Im Fall eines an das Subsystem angeschlossenen Umrichtersystems - in Fig. 2 kann das Betriebsmittel 6 als ein solches Umrichtersystem aufgefasst werden - ist in der Zuleitung des Subsystems 4 eine elektrische Schutzvorrichtung 50 zur Erkennung einer Unterbrechung einer Schutzleiterverbindung bei Umrichterbetrieb angeordnet.

Die elektrische Schutzvorrichtung 50 für Subsysteme 4 mit Umrichtersystem umfasst eine Vorrichtung 52 zur Messung eines Ableitstroms, eine Recheneinheit 54 zur Berechnung eines Ableitstromspektrums sowie eine Auswertungs-Prozesseinheit 56 zur Prüfung der berechneten Ableitstromspektren und zur Signalisierung der Unterbrechung 20 der Schutzleiterverbindung 8. Dabei kann die Implementierung der elektrischen Schutzvorrichtung 50 in Form eines integrierten Kombigerätes 51 auf der Basis eines Gerätes zur Bestimmung der Netzqualität als bauliche Einheit erfolgen.

Sofern nicht Schutzleiterverbindungen zu weiteren Subsystemen zu überwachen sind, kann die nicht für Umrichterbetrieb vorgesehene elektrische Schutzvorrichtung 40 entfallen.

## Patentansprüche

1. Verfahren zur Erkennung einer Unterbrechung (20) einer Schutzleiterverbindung (8) zu einem Subsystem (4) eines ungeerdeten Stromversorgungssystems (2), umfassend:
- Messen einer Referenz-Gesamtnetzableitkapazität und einer Referenz-Gesamtleistung des ungeerdeten Stromversorgungssystems (2) in einem fehlerfreien Zustand des ungeerdeten Stromversorgungssystems (2) bei eingeschaltetem Subsystem (4),
und umfassend die wiederholt durchzuführenden Verfahrensschritte:
- Messen einer aktuellen Gesamtnetzableitkapazität des ungeerdeten Stromversorgungssystems (2),
- Messen einer über das ungeerdete Stromversorgungssystem (2) aufgenommenen aktuellen Gesamtleistung,
- Prüfen, ob die aktuelle Gesamtnetzableitkapazität gegenüber der Referenz-Gesamtnetzableitkapazität um eine Teilnetzableitkapazität des Subsystems (4) verringert ist,
- Prüfen, ob die über das ungeerdete Stromversorgungssystem (2) aufgenommene aktuelle Gesamtleistung gegenüber der Referenz-Gesamtleistung um eine von dem Subsystem (4) im eingeschalteten Zustand aufgenommene Teilleistung verringert ist,
- Signalisieren, dass eine Unterbrechung (20) der Schutzleiterverbindung (8) vorliegt, falls die Prüfungen ergeben, dass die aktuelle Gesamtnetzableitkapazität verringert ist und die aktuelle Gesamtleistung nicht verringert ist.

2. Verfahren zur Erkennung einer Unterbrechung (20) einer Schutzleiterverbindung (8) zu einem Subsystem (4) eines geerdeten Stromversorgungssystems (3), umfassend:
- Messen eines Referenz-Gesamtdifferenzstroms und einer Referenz-Gesamtleistung des geerdeten Stromversorgungssystems (3) in einem fehlerfreien Zustand des geerdeten Stromversorgungssystems (3) bei eingeschaltetem Subsystem (4),
und umfassend die wiederholt durchzuführenden Verfahrensschritte:
- Messen eines aktuellen Gesamtdifferenzstroms des geerdeten Stromversorgungssystems (3),
- Messen einer über das geerdete Stromversorgungssystem (3) aufgenommenen aktuellen Gesamtleistung,
- Prüfen, ob der aktuelle Gesamtdifferenzstrom gegenüber dem Referenz-Gesamtdifferenzstrom um einen Teildifferenzstrom des Subsystems (4) gesunken ist,
- Prüfen, ob die über das geerdete Stromversorgungssystem (3) aufgenommene aktuelle Gesamtleistung gegenüber der Referenz-Gesamtleistung um eine von dem Subsystem (4) im eingeschalteten Zustand aufgenommene Teilleistung verringert ist,
- Signalisieren, dass eine Unterbrechung (20) der Schutzleiterverbindung (8) vorliegt, falls die Prüfungen ergeben, dass der aktuelle Gesamtdifferenzstrom verringert ist und die aktuelle Gesamtleistung nicht verringert ist.

3. Verfahren nach Anspruch 1 oder 2,
**dadurch gekennzeichnet,**
**dass** das Ermitteln der Referenzwerte Referenz-Gesamtnetzableitkapazität oder Referenz-Gesamtdifferenzstrom bei einer Erstinbetriebnahme und unmittelbar nach einer Wiederholungsprüfung des Stromversorgungssystems (2, 3) erfolgt.

4. Verfahren nach einem der Ansprüche 1 bis 3,
**dadurch gekennzeichnet,**
**dass** das Ermitteln der Referenzwerte Referenz-Gesamtnetzableitkapazität oder Referenz-Gesamtdifferenzstrom durch eine Filterung der gemessenen Werte erfolgt.

5. Elektrische Schutzvorrichtung (30) zur Erkennung einer Unterbrechung (20) einer Schutzleiterverbindung (8) zu einem Subsystem (4) eines ungeerdeten Stromversorgungssystems (2),
**gekennzeichnet durch**
eine Vorrichtung (32) zur Messung einer Gesamtnetzableitkapazität des ungeerdeten Stromversorgungssystems (2), durch eine Vorrichtung (34) zur Messung einer über das ungeerdete Stromversorgungssystem (2) aufgenommenen Gesamtleistung sowie durch eine Auswertungs-Prozesseinheit (36) zur Prüfung der gemessenen Gesamtnetzableitkapazität und der gemessenen aufgenommenen Gesamtleistung und zur Signalisierung der Unterbrechung (20) der Schutzleiterverbindung (8), wobei die Auswertungs-Prozesseinheit (36) so konfiguriert ist, dass sie die Verfahrensschritte nach Anspruch 1 ausführt.

6. Elektrische Schutzvorrichtung (30) nach Anspruch 5,
**dadurch gekennzeichnet,**
**dass** die Vorrichtung (32) zur Messung der Gesamtnetzableitkapazität und ein Isolationsüberwachungsgerät (12) ein erweitertes Isolationsüberwachungsgerät (38) als bauliche Einheit ausbilden.

7. Elektrische Schutzvorrichtung (30) nach Anspruch 6,
**dadurch gekennzeichnet,**
**dass** das erweiterte Isolationsüberwachungsgerät (38), die Vorrichtung (34) zur Messung der über das ungeerdete Stromversorgungssystem aufgenommenen Gesamtleistung und die Auswertungs-Prozesseinheit (36) ein integriertes Kombigerät (31) zur Erkennung einer Schutzleiterunterbrechung (20) als bauliche Einheit ausbilden.

8. Elektrische Schutzvorrichtung (40) zur Erkennung einer Unterbrechung (20) einer Schutzleiterverbindung (8) zu einem Subsystem (4) eines geerdeten Stromversorgungssystems (3), die elektrische Schutzvorrichtung umfassend eine Vorrichtung (42) zur Messung eines Gesamtdifferenzstroms des geerdeten Stromversorgungssystems (3), eine Vorrichtung (44) zur Messung einer über das geerdete Stromversorgungssystem (3) aufgenommenen Gesamtleistung sowie eine Auswertungs-Prozesseinheit (46) zur Prüfung des gemessenen Gesamtdifferenzstroms und der gemessenen aufgenommenen Gesamtleistung und zur Signalisierung der Unterbrechung (20) der Schutzleiterverbindung (8),
**dadurch gekennzeichnet, dass** die Auswertungs-Prozesseinheit (46) so konfiguriert ist, dass sie die Verfahrensschritte nach Anspruch 2 ausführt.

9. Elektrische Schutzvorrichtung (40) nach Anspruch 8,
**dadurch gekennzeichnet,**
**dass** die Vorrichtung (42) zur Messung des Gesamtdifferenzstroms, die Vorrichtung (44) zur Messung der über das geerdete Stromversorgungssystem aufgenommenen Gesamtleistung und die Auswertungs-Prozesseinheit (46) ein integriertes Kombigerät (41) auf der Basis eines Gerätes zur Bestimmung der Netzqualität als bauliche Einheit ausbilden.

## Claims

1. A method for detecting a disconnection (20) of a protective conductor connection (8) with a subsystem (4) of an ungrounded power supply system (2), comprising:
- measuring a reference total network leakage capacitance and a reference total power of the ungrounded power supply system (2) in a fault-free state of the ungrounded power supply system (2) when the subsystem (4) is switched on,
and comprising the method steps to be repeatedly executed:
- measuring a current total network leakage capacitance of the ungrounded power supply system (2),
- measuring a current total power consumed via the ungrounded power supply system (2),
- testing whether the current total network leakage capacitance is reduced by a partial network leakage capacitance of the subsystem (4) compared to the reference total network leakage capacitance,
- testing whether the current total power consumed via the ungrounded power supply system (2) is reduced by a partial power consumed by the sub system (4) in the switched-on state compared to the reference total power,
- signaling that there is a disconnection (20) of the protective conductor connection (8) if the tests reveal that the current total network leakage capacitance is reduced and the current total power is not reduced.

2. A method for detecting a disconnection (20) of a protective conductor connection (8) with a subsystem (4) of a grounded power supply system (3), comprising:
- measuring a reference total differential current and a reference total power of the grounded power supply system (3) in a fault-free state of the grounded power supply system (3) when the subsystem (4) is switched on,
and comprising the method steps to be repeatedly executed:
- measuring a current total differential current of the grounded power supply system (3),
- measuring a current total power consumed via the grounded power supply system (3),
- testing whether the current total differential current has dropped by a partial differential current of the subsystem (4) compared to the reference total differential current,
- testing whether the current total power consumed via the grounded power supply system (3) is reduced by a partial power consumed by the sub system (4) in the switched-on state compared to the reference total power,
- signaling that there is a disconnection (20) of the protective conductor connection (8) if the tests reveal that the current total differential current is reduced and the current total power is not reduced.

3. The method according to claim 1 or 2,
**characterized in that**
the reference values reference total network leakage capacitance or reference total differential current are each determined when the power supply system (2, 3) is activated for the first time and immediately after a repeat test of the power supply system (2, 3).

4. The method according to any one of claims 1 to 3,
**characterized in that**
the reference values reference total network leakage capacitance or reference total differential current are each determined by filtering the measured values.

5. An electrical protection device (30) for detecting a disconnection (20) of a protective conductor connection (8) with a subsystem (4) of an ungrounded power supply system (2),
**characterized by**
a device (32) for measuring a total network leakage capacitance of the ungrounded power supply system (2), by a device (34) for measuring a total power consumed via the ungrounded power supply system (2) and by an evaluating process unit (36) for testing the measured total network leakage capacitance and the measured total power consumed and for signaling the disconnection (20) of the protective conductor connection (8), the evaluating process unit (36) being configured so as to carry out the process steps according to claim 1.

6. The electrical protection device (30) according to claim 5,
**characterized in that**
the device (32) for measuring the total network leakage capacitance and an insulation monitoring device (12) form an extended insulation monitoring device (38) as a structural unit.

7. The electrical protection device (30) according to claim 6,
**characterized in that**
the extended insulation monitoring device (38), the device (34) for measuring the total power consumed via the ungrounded power supply system and the evaluating process unit (36) form an integrated combined device (31) as a structural unit for detecting a protective conductor disconnection (20).

8. An electrical protection device (40) for detecting a disconnection (20) of a protective conductor connection (8) with a subsystem (4) of a grounded power supply system (3), the electrical protection device (40) comprising
a device (42) for measuring a total differential current of the grounded power supply system (3), a device (44) for measuring a total power consumed via the grounded power supply system (3) and an evaluating process unit (46) for testing the measured total differential current and the measured total power consumed and for signaling the disconnection (20) of the protective conductor connection (8),
**characterized in that**
the evaluating process unit (46) is configured so as to carry out the process steps according to claim 2.

9. The electrical protection device (40) according to claim 8,
**characterized in that**
the device (42) for measuring the total differential current, the device (44) for measuring the total power consumed via the grounded power supply system and the evaluating process unit (46) form an integrated combined device (41) as a structural unit on the basis of a device for determining network quality.

## Revendications

1. Procédé pour détecter une interruption (20) d'une connexion de conducteur de protection (8) avec un sous-système (4) d'un système d'alimentation électrique (2) non mis à la terre, comprenant :
- mesurer une capacité de fuite totale du réseau de référence et une puissance totale de référence du système d'alimentation électrique (2) non mis à la terre dans un état sans erreur du système d'alimentation électrique (2) non mis à la terre lorsque le sous-système (4) est allumé,
et comprenant les étapes du procédé à exécuter de manière répétée :
- mesurer une capacité de fuite totale actuelle du système d'alimentation électrique (2) non mis à la terre,
- mesurer une puissance totale consommée par le système d'alimentation électrique (2) non mis à la terre,
- vérifier si la capacité de fuite totale actuelle du réseau est réduite d'une capacité de fuite partielle du réseau du sous-système (4) par rapport à la capacité de fuite totale du réseau de référence,
- vérifier si la puissance totale actuelle consommée par le système d'alimentation électrique (2) non mis à la terre est réduite d'une partie de la puissance consommée par le sous-système (4) par rapport à la puissance totale de référence à l'état allumé,
- signaler qu'il y a une interruption (20) de la connexion du conducteur de protection (8) si les tests montrent que la capacité de fuite totale du réseau est réduite et que la puissance totale actuelle n'est pas réduite.

2. Procédé pour détecter une interruption (20) d'une connexion de conducteur de protection (8) avec un sous-système (4) d'un système d'alimentation électrique (3) mis à la terre, comprenant :
- mesurer un courant différentiel total de référence et une puissance totale de référence du système d'alimentation électrique (3) mis à la terre dans un état sans erreur du système d'alimentation électrique (3) mis à la terre lorsque le sous-système (4) est allumé, et comprenant les étapes du procédé à exécuter de manière répétée :
- mesurer un courant différentiel total actuel du système d'alimentation électrique (3) mis à la terre,
- mesurer un courant total consommé par le système d'alimentation électrique (3) mis à la terre,
- vérifier si le courant différentiel total actuel est réduite d'un courant différentiel partielle du sous-système (4) par rapport du courant différentiel total de référence,
- vérifier si la puissance totale actuelle consommée par le système d'alimentation électrique (3) mis à la terre est réduite d'une partie de la puissance consommée par le sous-système (4) par rapport à la puissance totale de référence à l'état allumé,
- signaler qu'il y a une interruption (20) de la connexion du conducteur de protection (8) si les tests montrent que le courant différentiel total est réduit et que la puissance totale actuelle n'est pas réduite.

3. Procédé selon la revendication 1 ou 2,
**caractérise en ce que**
les valeurs de référence de la capacité de fuite totale du réseau de référence ou du courant différentiel total de référence sont déterminés lorsque le système d'alimentation électrique (2, 3) est mis en service pour la première fois et immédiatement après un test de reprise du système d'alimentation électrique (2, 3).

4. Procédé selon l'une quelconque des revendications 1 à 3,
**caractérisé en ce que**
les valeurs de référence de la capacité de fuite totale du réseau de référence ou du courant différentiel de référence total sont déterminés par filtrage des valeurs mesurées.

5. Dispositif de protection électrique (30) pour détecter une interruption (20) dans une connexion de conducteur de protection (8) avec un sous-système (4) d'un système d'alimentation non mis à la terre (2),
**caractérisé par**
un dispositif (32) pour mesurer une capacité de fuite totale du système d'alimentation électrique non mis à la terre (2), par un dispositif (34) pour mesurer une puissance totale consommée par l'intermédiaire du système d'alimentation (2) non mis à la terre et par une unité processus d'évaluation (36) pour vérifier la capacité totale de fuite du réseau mesurée et la puissance totale mesurée consommée et pour signaler l'interruption (20) du connexion du conducteur de protection(8), l'unité processus d'évaluation (36) étant réalisée de manière à effectuer les étapes du procédé selon la revendication 1.

6. Dispositif de protection électrique (30) selon la revendication 5,
**caractérisé en ce que**
le dispositif (32) pour mesurer la capacité de fuite totale du réseau et un dispositif de surveillance d'isolement (12) forment un dispositif de surveillance d'isolement étendu (38) comme unité structurelle.

7. Dispositif de protection électrique (30) selon la revendication 6,
**caractérisé en ce que**
le dispositif de surveillance d'isolement étendu (38), le dispositif (34) pour mesurer la puissance totale consommée via le système d'alimentation non mis à la terre et l'unité processus d'évaluation (36) forment un dispositif combiné intégré (31) pour détecter une interruption (20) du connexion du conducteur de protection comme unité structurelle.

8. Dispositif de protection électrique (40) pour détecter une interruption (20) d'une connexion de conducteur de protection (8) avec un sous-système (4) d'un système d'alimentation électrique mis à la terre (3), le dispositif de protections électrique (40) comprenant un dispositif (42) pour mesurer un courant différentiel total du système d'alimentation mis à la terre (3), un dispositif (44) pour mesurer une puissance totale consommée par l'intermédiaire du système d'alimentation électrique mis à la terre (3) et une unité processus d'évaluation (46) pour vérifier le courant différentiel total mesuré et la puissance totale mesurée consommée et pour signaler l'interruption (20) de la connexion (8) du conducteur de protection,
**caractérisé en ce que**
l'unité processus d'évaluation (46) est configurée de telle sorte qu'elle exécute les étapes de procédé selon la revendication 2.

9. Dispositif de protection électrique (40) selon la revendication 8,
**caractérisé en ce que**
le dispositif (42) pour mesurer le courant différentiel total, le dispositif (44) pour mesurer la puissance totale consommée via le système d'alimentation mis à la terre et l'unité processus d'évaluation (46) forment un dispositif combiné intégré (41) sur la base d'un dispositif pour déterminer la qualité du réseau comme unité structurelle.
